# EUROPEAN PATENT APPLICATION

(11) **EP 4 421 557 A1**
(43) Date of publication of application: **28.08.2024**
(21) Application number: 24150095.8
(22) Date of filing: 02.01.2024
(51) Int. Cl.: G02F 1/1333, E06B 9/24, G02B 5/30, G02F 1/1335

(54) **VARIABLE TRANSMITTANCE OPTICAL STACK AND MANUFACTURING METHOD FOR SAME, AND SMART WINDOW INCLUDING SAME**

(30) Priority: 21.02.2023 KR 20230022847
(71) Applicant: Dongwoo Fine-Chem Co., Ltd., Iksan-si, Jeollabuk-do 54631 (KR)
(72) Inventor: KIM, Sung-Su, 54631 Jeollabuk-do (KR); KIM, Dong-Hwi, 54631 Jeollabuk-do (KR); BAEK, Sung-Ho, 54631 Jeollabuk-do (KR)
(74) Representative: Betten & Resch

(57) **Abstract**

A variable transmittance optical stack and a manufacturing method thereof, and a smart window including the same are proposed. The variable transmittance optical stack includes a liquid crystal layer; a first transparent conductive layer formed on a first surface of the liquid crystal layer; a second transparent conductive layer formed on a second surface of the liquid crystal layer; a first polarizing plate formed on the first transparent conductive layer; and a second polarizing plate formed on the second transparent conductive layer, and at least one of the first polarizing plate and the second polarizing plate includes a coatable polarizer, and transmission axis of the first polarizing plate and the second polarizing plate are respectively vertical to each other.

## Description

### CROSS REFERENCE TO RELATED APPLICATION

The present application claims priority to Korean Patent Application No. 10-2023-0022847, filed February 21, 2023, the entire contents of which are incorporated herein for all purposes by this reference.

### BACKGROUND OF THE INVENTION

### Field of the Invention

The present disclosure relates to a variable transmittance optical stack, a manufacturing method for the same, and a smart window including the same.

### Description of the Related Art

In general, there are many cases in which an external light blocking coating is applied to a window of a means of transportation such as a vehicle. However, a transmittance of a conventional window of a means of transportation is fixed, and a transmittance of the external light blocking coating is also fixed. Therefore, the entire transmittance of the conventional window of the means of transportation is fixed, thereby causing an accident. For example, when the entire transmittance is preset low, there is no problem during day when ambient light is sufficient. However, there is a problem in that it is difficult for a driver or the like to properly check the surroundings of the means of transportation at night when ambient light is insufficient. Alternatively, when the entire transmittance is preset high, there is a problem of causing glare to a driver or the like during day when ambient light is sufficient. Furthermore, there are many cases in which an external light blocking coating is applied to a window of a building in order to achieve efficiency of cooling and heating and energy saving. When the transmittance is not fixed, as in the means of transportation, efficiency in energy saving may not be achieved, which is a problem.

Accordingly, a variable transmittance optical stack capable of changing the transmittance of light when a voltage is applied has been developed. The variable transmittance optical stack is driven by varying transmittance by driving a liquid crystal according to the application of voltage. The variable transmittance optical stack includes the liquid crystal layer with a phase that is changed as an electric field is applied in order to vary the transmittance, thereby achieving a desired transmittance.

In Japan Patent Application Publication No. 2018-010035, a variable transmittance optical stack including a transparent electrode layer formed on a polycarbonate (PC) substrate, etc. with a predetermined thickness. In this case, a size of a product is limited within a width of the polarizing plate and is limited to provide a stack with a large area.

Therefore, there is a need to develop a variable transmittance optical stack that can provide a large area smart window without deteriorating transmittance.

### Documents of Related Art

(Patent Document 1) Japan Patent Application Publication No. 2018-010035

### SUMMARY OF THE INVENTION

In order to solve the above-described problems, the present disclosure is intended to provide a variable transmittance optical stack with a large area that uses a polarizing plate and may be applied to a building.

Another objective of the present disclosure is to provide a smart window including the variable transmittance optical stack, and windows and doors for a vehicle or a building, to which the same is applied.

However, the problem to be solved by the present disclosure is not limited to the problems mentioned above, and other problems not mentioned will be clearly understood by those skilled in the art from the description below.

According to the present disclosure, there is provided a variable transmittance optical stack including: a liquid crystal layer; a first transparent conductive layer formed on a first surface of the liquid crystal layer; a second transparent conductive layer formed on a second surface of the liquid crystal layer; a first polarizing plate formed on the first transparent conductive layer; and a second polarizing plate formed on the second transparent conductive layer, wherein at least one polarizing plate of the first polarizing plate and the second polarizing plate may include a coatable polarizer, and each transmission axis of the first polarizing plate and the second polarizing plate may be vertical.

Machine directions (MD) of the first polarizing plate and the second polarizing plate may be in parallel to each other.

The first polarizing plate may include a stretched polarizer, and the second polarizing plate comprises the coatable polarizer.

The variable transmittance optical stack may be manufactured by a roll-to-roll continuous process.

At least one polarizing plate of the first polarizing plate and the second polarizing plate may include one or more types of a functional layer selected from a group consisting of a functional coating layer, a protective layer, a retardation matching layer, and a refractive index-matching layer.

At least one polarizing plate of the first polarizing plate and the second polarizing plate may have a thickness ranging from 30 to 200µm.

At least one transparent conductive layer of the first transparent conductive layer and the second transparent conductive layer may be formed by directly contacting with any one polarizing plate of the first polarizing plate and the second polarizing plate without a separate or additional substrate between the polarizing plate and the transparent conductive layer.

At least one transparent conductive layer of the first transparent conductive layer and the second transparent conductive layer may be formed by directly contacting with any one polarizing plate of the first polarizing plate and the second polarizing plate with a highly adhesive layer between the polarizing plate and the transparent conductive layer.

At least one transparent conductive layer of the first transparent conductive layer and the second transparent conductive layer may include one or more types selected from a group consisting of transparent conductive oxide, metal, carbonaceous matters, conductive polymers, conductive ink, and nanowires.

The liquid crystal layer may be driven in a twisted nematic (TN) mode.

The liquid crystal layer may include one or more types of spacers selected from a group consisting of a ball spacer and a column spacer.

The variable transmittance optical stack may further include one or more types selected from a group consisting of a sealant, an alignment film, a pressure sensitive adhesive/adhesive layer, and an ultraviolet ray absorption layer.

The present disclosure relates to a manufacturing method for a variable transmittance optical stack.

The manufacturing method of the variable transmittance optical stack may be characterized as being a roll-to-roll continuous process.

The present disclosure relates to a smart window comprising a variable transmittance optical stack.

The present disclosure relates to a means of transportation comprising a smart window, and may relate to a vehicle in which a smart window is applied to at least one of a front window, a rear window, a side window, a sunroof window, and an inner partition thereof.

The present disclosure relates to a wearable device comprising a smart window, and may be a window and a door for a building, the window and the door including a smart window.

According to the present disclosure, the variable transmittance optical stack may adjust the visible ray transmittance in response to voltage application.

Furthermore, according to the present disclosure, the variable transmittance optical stack may provide the variable transmittance optical stack with a large area that may be applicable to a building.

### BRIEF DESCRIPTION OF THE DRAWINGS

FIG. 1 is a view schematically showing a stack structure of a variable transmittance optical stack according to an embodiment of the present disclosure.
FIG. 2 is a view showing a stack structure of a variable transmittance optical stack according to an embodiment of the present disclosure.

### DETAILED DESCRIPTION OF THE DISCLOSURE

The present disclosure relates to a variable transmittance optical stack and a manufacturing method thereof, and a smart window including the same, and the variable transmittance optical stack can be provided with a large area by being manufactured by the roll-to-roll continuous process and can adjust transmittance in response to application of voltage. More specifically, the variable transmittance optical stack includes: a liquid crystal layer; a first transparent conductive layer formed on a first surface of the liquid crystal layer; a second transparent conductive layer formed on a second surface of the liquid crystal layer; a first polarizing plate formed on the first transparent conductive layer; and a second polarizing plate formed on the second transparent conductive layer, wherein at least one polarizing plate of the first polarizing plate and the second polarizing plate includes a coatable polarizer, and the first polarizing plate and the second polarizing plate have vertical transmission axis, respectively, and have machine directions MD that are in parallel to each other.

The variable transmittance optical stack of the present disclosure is particularly suitable for technical fields where light transmittance can be changed in response to application of voltage, for example, may be used for a smart window, etc.

The smart window is an optical structure controlling the amount of light or heat passing through the window by changing light transmittance in response to an electrical signal. In other words, the smart window is provided to be changed into a transparent, opaque or translucent state by voltage and is called variable transmittance glass, lighting control glass, or smart glass.

The smart window may be used as partitions for partitioning an internal space of vehicles and buildings or for protecting privacy, or as skylights arranged in openings of buildings, and may be used as highway signs, noticeboards, scoreboards, clocks or advertising screens, and may be used to replace glass of a means of transportation, such as windows or sunroof windows of cars, buses, aircrafts, ships, or trains.

The variable transmittance optical stack of the present disclosure may also be used for the smart window of the various technical fields mentioned above, but since the conductive layer is directly formed in the polarizing plate, there is no need to include a separate or additional substrate for forming the conductive layer and the thickness thereof is thin and is advantageous in the flexuosity, so the optical stack of the present disclosure may be used to be particularly suitable for a smart window of a vehicle or a building. According to one or a plurality of embodiments, the smart window to which the variable transmittance optical stack of the present disclosure is applied may be used for front windows, rear windows, side windows, and sunroof windows of a vehicle, or windows and doors for a building, and the smart window may be used to not only an external light blocking use, but also an internal space partitioning use or a privacy protecting use such as an inner partition for a vehicle or a building.

Hereinbelow, embodiments of the present disclosure will be described in detail with reference to drawings. However, the following drawings accompanied to this specification illustrate preferred embodiments of the present disclosure, and serve to further understand the technical idea of the present disclosure with the contents of the above-described invention. Therefore, the present disclosure should not be construed as being limited to matters described in the drawings.

Terms used in this specification are selected to describe embodiments and thus do not limit the present disclosure. In this specification, an element expressed in a singular form may be plural elements unless it is necessarily singular in the context. For example, "the polarizing plate" used in the specification may mean at least one polarizing plate of the first polarizing plate and the second polarizing plate, and "the transparent conductive layer" may mean at least one transparent conductive layer of the first transparent conductive layer and the second transparent conductive layer.

As used herein, terms "comprise" and/or "comprising" do not mean exclusion of the presence or absence of one or more components, steps, movements and/or elements other than a component, a step, movement, and/or an element mentioned above. The same reference numerals are used throughout the specification to designate the same or similar elements.

Spatially relative terms "below", "lower surface", and "lower portion", and "above", "upper surface", and "upper portion" may be used to easily describe correlation between "one element or components" and "another element or other components", as shown in drawings. The spatially relative terms should be understood as terms including different directions of an element when being used or operated in addition to a direction shown in the drawings. For example, when an element shown in the drawgins is turned over, the element described as being "below" or "lower" with respect to another element may be placed "on" the another element. Accordingly, the exemplary term "below" may include both downward and upward directions. An element may be aligned in a different direction, and accordingly, the spatially relative terms may be interpreted according to orientation.

The "planar direction" used in this specification may be interpreted as a direction perpendicular to a polarizing plate and/or a transparent conductive layer, that is, a direction viewed from the user's view side.

### <Variable transmittance optical stack>

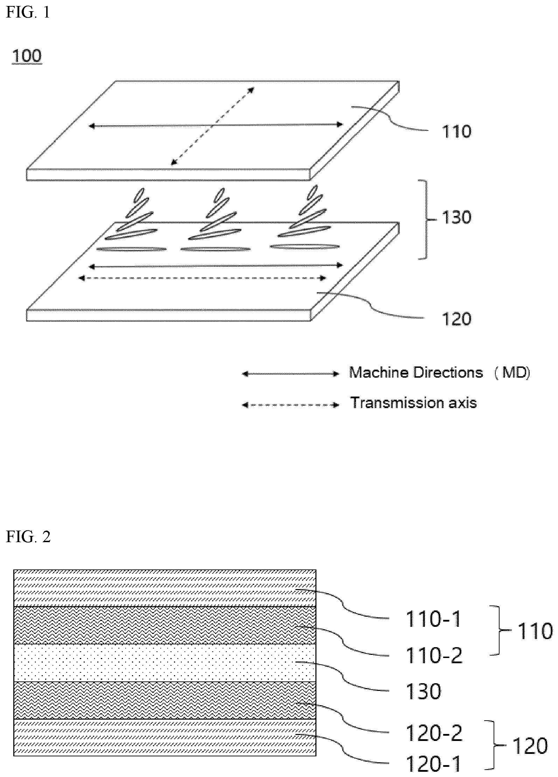

FIG. 1 is a view schematically showing a stack structure of a variable transmittance optical stack according to an embodiment of the present disclosure. FIG. 2 is a view showing a stack structure of a variable transmittance optical stack according to an embodiment of the present disclosure.

Referring to FIG. 1, according to the embodiment of the present disclosure, the variable transmittance optical stack may include a liquid crystal layer 130 formed between a first polarizing plate 110 and a second polarizing plate 120. Furthermore, a transmission axis of the first polarizing plate 110 and a transmission axis of the second polarizing plate 120 are vertical to each other, and machine directions MD thereof are in parallel to each other, so that manufacture of supersized optical stack may be possible. The term used in the specification, " machine direction or mechanical direction (MD, vertical direction or longitudinal direction)", means a direction in which each polarizing plate is returned in the roll-to-roll continuous process, i.e., a mechanical-flow direction.

Therefore, when the first polarizing plate 110 and the second polarizing plate 120 have the MDs that are arranged in parallel to each other in a planar direction, during manufacturing of the variable transmittance optical stack including the first and second polarizing plates, the roll-to-roll continuous process may be applied thereto and the process is continuous and economical so that manufacturing thereof can be efficiently performed. Furthermore, since there is no need to separately transfer an optical stack, even when the optical stack a the large area is manufactured handling problems such as bending or damaging to the stack does not occur so that the optical stack may be manufactured into a variable transmittance optical stack with a large area.

Furthermore, according to the embodiment of the present disclosure, at least one polarizing plate of the first polarizing plate 110 and the second polarizing plate 120 includes a coatable polarizer. More specifically, it is preferable that the first polarizing plate 110 includes a stretched polarizer and the second polarizing plate 120 includes a coatable polarizer by adjusting the machine directions to be in parallel to each other and the transmission axis to be vertical, in terms of manufacturing the optical stack including the liquid crystal layer to which a TN mode.

According to the embodiment, the stretched polarizer may include a stretched polyvinyl alcohol (PVA)-based resin. The PVA-based resin may be PVA-based resin obtained by saponifying polyvinyl acetate resin. In addition to polyvinyl acetate that is homopolymer of vinyl acetate, vinyl acetate and a copolymer with other monomers that can be copolymerized with vinyl acetate may be used as the polyvinyl acetate-based resin. As the other monomers, unsaturated carboxylic acid-based monomers, unsaturated sulfonic acid-based monomers, olefin-based monomers, vinyl ether-based monomers, acrylamide having ammonium groups-based monomers, and the like may be used. Furthermore, the PVA-based resin contains a denatured resin, and for example, may be polyvinyl formal or polyvinyl acetal denatured into aldehyde.

According to the embodiment, the coatable polarizer may be formed of a composition for liquid crystal coating, and, at this point, the composition for liquid crystal coating may contain reactive liquid crystal compound, and dichroic dye, etc.

The reactive liquid crystal compound may mean a compound, for example, containing a mesogen frame, etc., and also containing one or more polymerizable functional groups. The reactive liquid crystal compound may be variously known by the name reactive mesogen (RM). The reactive liquid crystal compound may constitute a cured film with polymer network formed while being polymerized by light or heat and maintaining liquid crystal arrangement.

The reactive liquid crystal compound may be a mono-functional liquid crystal compound or a multi-functional liquid crystal compound. The mono-functional liquid crystal compound is a compound having 1 polymerizable functional group, and the multi-functional liquid crystal compound may mean a compound having two or more polymerizable functional groups.

The dichroic dye is a substance contained in the composition for liquid crystal coating to impart the polarization characteristic, and has a characteristic in which absorbance in a direction of long axis of molecule and absorbance in a direction of short axis are different. The dichroic dyes may adopt dichroic dyes currently developed or to be developed, and may contain one or more types of dyes selected from a group consisting of azo dyes, anthraquinone dyes, perylene dyes, merocyanine dyes, azomethine dyes, phthaloperylene dyes, indigo dyes, dioxazine dyes, polythiophene dyes, and phenoxazine dyes.

The composition for liquid crystal coating may contain a solvent capable of dissolving the reactive liquid crystal compound and the dichroic dye. For example, propylene glycol monomethyl ether acetate (PGMEA), methyl ethyl ketone (MEK), xylene, chloroform, and the like. Furthermore, the composition for liquid crystal coating may contain leveling agents, polymerization initiators, etc. within a range that does not deteriorate the polarization characteristics of a coating film.

According to one or a plurality of embodiments, at least one polarizing plate of the first polarizing plate and the second polarizing plate may include one or more functional layers selected from a group consisting of a functional coating layer, a protective layer, a retardation matching layer, and a refractive index-matching layer.

The functional coating layer is provided to improve hardness of the polarizing plate, and is not particularly limited as long as it can improve the hardness of the polarizing plate. For example, the functional coating layer may include a hard coating layer and/or a low refractive index layer. The hard coating layer may use a hard coating layer currently developed or to be developed, and according to an embodiment of the present disclosure, the hard coating layer may be formed from a hard coating composition including acrylic or epoxy compound and inorganic microparticle, photoinitiator, etc. The acrylic compound may include monomer or oligomer including (meth) acrylate-group, and the term used in the specification, "(meth)acryl-" is used to refer to "methacryl-", "acryl-" or both. As non-restricted examples of the acrylic compound, there may be neopentylglycol diacrylate, 1,6-hexanediol (meth) acrylate, polypropyleneglycoldi (meth) acrylate, triethyleneglycoldi (meth) acrylate, dipropyleneglycoldi (meth) acrylate, polyethyleneglycoldi (meth) acrylate, polypropyleneglycoldi (meth) acrylate, trimethylolpropanetri (meth) acrylate, trimethylolethanetri (meth) acrylate, 1,2,4-cyclohexanetetra (meth) acrylate, pentaglycerolthri (meth) acrylate, pentaerythritol tetra (meth) acrylate, pentaerythritoltri (meth) acrylate, dipentaerythritoltri (meth) acrylate, dipentaerythritolpenta (meth) acrylate, dipentaerythritoltetra (meth) acrylate, dipentaerythritolhexa (meth) acrylate, tripentaerythritoltri (meth) acrylate, tripentaerythritolhexatri (meth) acrylate, bis (2-hydroxyethyl)isocyanuratedi (meth) acrylate, hydroxyethyl (meth) acrylate, hydroxypropyl (meth) acrylate, hydroxybutyl (meth) acrylate, isooctyl (meth) acrylate, iso-dexil (meth) acrylate, stearyl (meth) acrylate, tetrahydrofurfuryl (meth) acrylate, phenoxyethyl (meth) acrylate, or isoboneol (meth) acrylate. The solvents may be used alone or combination of two or more types. The acrylic compound may contain an epoxy (meth) acrylate compound and/or a urethane (meth) acrylate compound. Furthermore, the epoxy compound may contain a monomer with at least one epoxy group in a molecule or an oligomer. The epoxy group may be an alicyclic epoxy group. The carbon number of an alicyclic ring included in the epoxy group may be between 3 and 7, and for example, may be alicyclic epoxy group containing a cyclohexane ring (cyclohexylepoxy). The alicyclic ring may have a substituent. For example, the alicyclic ring may include an alkyl substituent having 1 to 20 carbon atoms. When the carbon number of the alkyl substituent exceeds 20, it may be disadvantageous in terms of curing speed. The alkyl substituent may include a straight-chain type or a branched type, and in the case of the branched type, the carbon number may be 10 or more.

In a manufacturing method of the hard coating layer, the hard coating composition may contain an inorganic microparticle. The inorganic microparticle may use an inorganic microparticle, which has a nanoscale particle size, and for example, may use a nanoparticle with a particle size of 100nm or less, preferably between 10 and 100nm, more preferably between 10 and 50nm. Furthermore, the inorganic microparticle may for example use silica microparticle, aluminum oxide particle, titanium oxide particle, zinc oxide particle, or the like.

As the inorganic microparticle is contained, the hardness of the hard coating layer can be further improved. The inorganic microparticle may be contained as between 10 and 60 parts by weight with respect to 100 parts by weight of the hard coating composition, preferably as between 20 and 50 parts by weight, but is not limited thereto.

According to an embodiment of the present disclosure, in the manufacturing method of the hard coating layer, the hard coating composition may contain an photoinitiator. According to an embodiment of the present disclosure, the photoinitiator may be 1-hydroxy-cyclohexyl-phenylketone, 2-hydroxy-2-methyl-1-phenyl-1-propanone, 2-hydroxy-1 -[4-(2-hydroxyethoxy)phenyl]-2-methyl-1 -propanone, methylbenzoylformate, α,α-dimethoxy-α-phenylacetophenone, 2-benzoyl-2-(dimethylamino)-1-[4-(4-morpholineyl)phenyl]-1-butanone, 2-methyl-1-[4-(methylthio)phenyl]-2-(4-morpholineyl)-1-propanonediphenyl(2,4,6-trimethylbenzoyl)-phosphineoxide or bis(2,4,6-trimethylbenzoyl)-phenylphosphineoxide, etc., but is not limited thereto. Furthermore, currently available products may include Irgacure 184, Irgacure 500, Irgacure 651, Irgacure 369, Irgacure 907, Darocur 1173, Darocur MBF, Irgacure 819, Darocur TPO, Irgacure 907, Esacure KIP 100F, etc. The photoinitiator may be used alone or as two different types are mixed.

According to an embodiment of the present disclosure, the photoinitiator may be contained as between 0.5 and' 10 parts by weight with respect to 100 parts by weight of the hard coating composition, particularly between 1 and 5 parts by weight. When the photoinitiator is within the above range, sufficient cross-linking photopolymerization can be achieved without deteriorating physical properties of the hard coating layer.

Meanwhile, in a manufacturing method of the hard coating layer of the present disclosure, in addition to the above-described components, the hard coating composition may include additives commonly used in the technical field to which the present disclosure belongs, such as a surfactant, a yellowing inhibitor, a leveling agent, an antifouling agent, etc. Furthermore, the content may be variously adjusted within a range that does not deteriorate the physical properties of the hard coating composition according to the present disclosure, and is not particularly limited.

The low refractive index layer may be provided to also improve the hardness of the polarizing plate within a range that does not impair the objectives of the present disclosure. The low refractive index layer, for example, may include one or more of low refractive index agents selected from a group consisting of SiO₂, Al₂O₃, MgF₂, CaF, cryloite, etc., and in some embodiments, a compound used in the hard coating layer, and other resins commonly used in the technical field to which the present disclosure belongs. The hard coating layer and the low refractive index layer may be each used alone, and in some embodiments, may be used as a multiple-layered structure.

The functional coating layer may be formed by directly contacting with one surface of the polarizer, but is not limited thereto. For example, when the polarizing plate includes the retardation matching layer and/or the refractive index-matching layer, the functional coating layer is formed on one surface of the retardation matching layer and the refractive index-matching layer, so that the functional coating layer, the retardation matching layer, the refractive index-matching layer, and the polarizer may be laminated in order.

The functional coating layer is preferably formed on a side toward the liquid crystal layer of the polarizer, i.e., on an inner side of the polarizer, but is not limited thereto, and may be also formed on an outer side of the polarizer so that the polarizer, the functional coating layer, and the protective layer may be laminated in order. In this case, the functional coating layer may give the polarizing plate the hardness with a level suitable for forming members such as the transparent conductive layer, and therefore it has the advantage of minimizing cracks or scratches occurring in the manufacturing or processing of the optical stack.

The functional coating layer may have excellent wear resistance and may have improved flexibility and durability of the optical stack, and specifically may efficiently prevent defects such as cracks of the conductive layers from occurring due to pressure application by the spacer or a chemical reaction of the liquid crystal, the alignment film, etc., in the bonding process of the optical stack.

According to one or a plurality of embodiments, a thickness of the functional coating layer after drying may be between 1 and 50µm, preferably may be between 1 and 40µm, but is not limited thereto.

The protective layer is provided to preserve the polarization characteristic of the polarizer from a post-processing and external environment, and may be implemented into a form such as a protective film, etc.

The protective layer may be formed by directly contacting with one or opposite surfaces of the polarizer, but is not limited thereto. For example, the protective layer may be used as a double layer structure in which one or more protective layers are successively laminated, and may be formed in directly contact with another member such as the retardation matching layer.

According to one or a plurality of embodiments, the protective layer may include one or more types selected from a group consisting of polyethylene terephthalate (PET), polyethylene isophthalate (PEI), polyethylene naphthalate (PEN), polybutylene terephthalate (PBT), diacetyl cellulose, triacetyl cellulose (TAC), polycarbonate (PC), polyethylene (PE), polypropylene (PP), polymethyl acrylate (PMA), polymethyl methacrylate (PMMA), polyethyl acrylate (PEA), polyethyl methacrylate (PEMA), and cyclic olefin polymer (COP).

Furthermore, the protective layer may include an ultraviolet absorber at the outermost surface thereof in order to prevent functional deterioration of the optical stack. The ultraviolet absorber is not particularly limited as long as it is to prevent deterioration of the optical stack due to UV rays. For example, the ultraviolet ray absorption layer may use salicylic acid-based ultraviolet absorber (phenyl salicylate, p-tert-butylsalicylate, etc.), benzophenone-based ultraviolet absorber(2,4-dihydroxybenzophenone, 2,2'-dihydroxy-4,4'-dimethoxybenzophenone, etc.), benzotriazole-based ultraviolet absorber (2-(2'-hydroxy-5'-methylphenyl)benzotriazole, 2-(2'-hydroxy-3',5'-di-tert-butylphenyl)benzotriazole, 2-(2'-hydroxy-3'-tert-butyl-5'-methylphenyl)benzotriazole, 2-(2'-hydroxy-3',5'-di-tert-butylphenyl)-5-chlorobenzotriazole, 2-(2'-hydroxy-3'-(3",4",5",6"-tetrahydrophthalimide methyl)-5'-methylphenyl)benzotriazole, 2,2-methylenebis(4-(1,1,3,3-tetramethylbutyl)-6-(2H-benzotriazole-2-yl)phenol), 2-(2'-hydroxy-3'-tert-butyl-5'-methylphenyl)-5-chlorobenzotriazole, 2-(2'-hydroxy-3'-tert-butyl-5'-(2-octyloxicarbonylethyl)-phenyl)-5-chlorobenzotriazole, 2-(2'-hydroxy-3'-(1-methyl-1-phenylethyl)-5'-(1,1,3,3-tetramethylbutyl)-phenyl)benzotriazole, 2-(2H-benzotriazole-2-yl)-6-(linear and side chain dodecyl)-4-methylphenol, octyl-3-[3-tert-butyl-4-hydroxy-5-(chloro-2H-benzotriazole-2-yl)phenyl]propionate and 2-ethylhexyl-3-[3-tert-butyl-4-hydroxy-5-(5-chloro-2H-benzotriazole-2-yl)phenyl]propionate compounds, etc.), cyanoacrylate-based ultraviolet absorber(2'-ethylhexyl-2-cyano-3,3-diphenylacrylate, ethyl-2-cyano-3-(3',4'-methylene dioxyphenyl)-acrylate, etc.), triazine-based ultraviolet absorber, etc.. The benzotriazole-based ultraviolet absorber or the triazine-based ultraviolet absorber that have high transparency and the excellent effect of preventing deterioration of a separate or additional substrate such as the polarizing plate may be preferably used as the ultraviolet ray absorption layer, and the benzotriazole-based ultraviolet absorber having more appropriate spectral absorption spectroscopy absorption spectrum may be preferable. The benzotriazole-based ultraviolet absorber may be changed into "-Bis" and, for example, may be 6,6'-methylenebis(2-(2H-benzo[d][1,2,3]triazole-2-yl)-4-(2,4,4-trimethylpentane-2-yl)phenol), 6,6'-methylenebis(2-(2H-benzo[d][1,2,3]triazole-2-yl)-4-(2-hydroxyethyl)phenol), etc.

The protective layer is provided to preserve the polarization characteristic of the polarizer from a post-processing and external environment, and may be implemented into a form such as a protective film, etc. The protective layer may be used as a double layer structure in which one or more protective layers are successively laminated, and may be formed by being combined with another functional layer.

According to one or a plurality of embodiments, the protective layer may include one or more types selected from a group consisting of polyethylene terephthalate (PET), polyethylene isophthalate (PEI), polyethylene naphthalate (PEN), polybutylene terephthalate (PBT), diacetyl cellulose, triacetyl cellulose (TAC), polycarbonate (PC), polyethylene (PE), polypropylene (PP), polymethyl acrylate (PMA), polymethyl methacrylate (PMMA), polyethyl acrylate (PEA), polyethyl methacrylate (PEMA), and cyclic olefin polymer (COP).

The retardation matching layer may be provided to complement optical properties of the optical stack, and may be implemented in a retardation film, and a retardation film currently developed or to be developed may be used therefor. For example, a quarter-wave plate (1/4 wave plat) or a half-wave plate (1/2 wave plat) may be used to delay a phase difference of light, and may be used alone or in combination.

The retardation matching layer may be formed by directly contacting with one surface of the polarizer, but is not limited thereto. For example, the retardation matching layer may be formed by directly contacting with one surface of the protective layer, and may be formed by directly contacting with one surface of the refractive index-matching layer.

The retardation matching layer may be a polymer stretched film or a liquid crystal polymerized film, formed by stretching a polymer film that can impart optical anisotropy by stretching in an appropriate manner.

According to the embodiment, the polymer stretched film may use a polymer layer including: polyolefin such as polyethylene (PE), polypropylene (PP), etc.; cyclo olefin polymer (COP) such as polynorbornene, etc.,; polyester such as polyvinyl chloride (PVC), polyacrylonitrile (PAN), polysulfone (PSU), acryl resin, polycarbonate (PC), polyethylene terephthalate (PET), etc.; and/or cellulose ester polymer such as polyacrylate, polyvinyl alcohol (PVA), triacetyl cellulose (TAC), etc., or a copolymer of two or more monomers among monomers that can form the polymers.

An obtaining method of the polymer stretched film is not particularly limited and, for example, may be obtained by forming the polymer material into a film shape and then stretching the material. The molding method for the film shape is not particularly limited, and the polymer stretched film may be formed in the known methods such as injection molding, sheet molding, blow molding, injection blow molding, inflation molding, extrusion molding, foaming molding, cast molding, etc., and may be formed in a secondary processing molding method such as pressure molding, vacuum molding, etc. Among them, extrusion molding and cast molding may be preferably used. At this point, for example, an unstretched film may be extruded by using an extruder to which a T-die, a circular die, etc., may be mounted. When a molded product is obtained in extrusion molding, a material made by melt-kneading various resin components, additives, etc., in advance, may be used and the molded product may be formed by melt-kneading during extrusion molding. Furthermore, various resin components are dissolved by using common solvent, for example, solvent such as chloroform, 2 methylen chloride, and then is solidified in a cast dry manner, and accordingly the non-stretched film may be cast-molded.

The polymer stretched film may be provided by performing uniaxial stretching with respect to the molded film in a machine direction or mechanical direction (MD, longitudinal or length direction), and by performing uniaxial stretching in a direction (TD, transverse direction or width direction) perpendicular to the MD, and furthermore, the molded film is stretched in a sequential biaxial stretching method of roll stretching and tenter stretching, a simultaneous biaxial stretching method of tenter stretching, a biaxial stretching method of tubular stretching, etc., so that a biaxial stretched film may be manufactured.

The liquid crystal polymerized film may contain reactive liquid crystal compound in a polymerized state. The description of the reactive liquid crystal compound of the coatable polarizer described above may be equally applied to the reactive liquid crystal compound.

According to one or a plurality of embodiments, when the retardation matching layer is a polymer stretched film, a thickness thereof may be between 10 and 100 µm for thinning the optical stack, and when the retardation matching layer is a liquid crystal polymerized film, a thickness thereof may be between 0.1 and 5µm, but the retardation matching layer is not limited thereto.

The refractive index-matching layer is provided to compensate for the refractive index difference of the optical stack by the transparent conductive layer, and may serve to improve the visible characteristic by reducing the difference of the refractive index. Furthermore, the refractive index-matching layer may be provided to correct a color based on the transparent conductive layer. Meanwhile, when a transparent conductive layer 110-2, 120-2 to be described below has a pattern, the refractive index-matching layer may correct the transmittance difference of a region with the pattern and a non-pattern region without the pattern.

Specifically, the transparent conductive layer is laminated close to other members having a refractive index different therefrom, and due to the difference of the refractive index between the transparent conductive layer and another layer close thereto, the difference of optical transmittance may be caused. Specifically, when a pattern is formed on the transparent conductive layer, a problem in that the pattern region and the non-pattern region are visually distinguished from each other. Therefore, the refractive index-matching layer is included to compensate for refractive index, thereby reducing the difference with the optical transmittance of the optical stack. Specifically, when a pattern is formed on the transparent conductive layer, the pattern region and the non-pattern region should be provided so as not to be visually distinguished.

According to the embodiment, the refractive index of the refractive index-matching layer may be appropriately selected according to a material of another adjacent member, and may be preferably between 1.4 and 2.6, more preferably, may be between 1.4 and 2.4. In this case, it is possible to prevent optical loss due to sharp difference of the refractive index between another member such as the polarizer and the transparent conductive layer.

The refractive index-matching layer is not particularly limited as long as it can prevent the sharply refractive difference between other members, and the transparent conductive layer, and may use a compound used in the formation of refractive index-matching layers currently developed or to be developed. For example, the refractive index-matching layer 150 may be formed from refractive index-matching layer formation composition including polymerizable isocyanate compound.

According to the embodiment, the polarizing plate 110, 120 may include other functional layers to assist or strengthen the characteristics of the polarizing plate in addition to the above-mentioned functional layers and, for example, may include an overcoat layer, etc. in order to further improve the mechanical durability.

According to one or a plurality of embodiments, the polarizing plate 110, 120 may have a thickness between 30 and 200 µm, and preferably, a thickness between 30 and 170 µm, and more particularly, a thickness between 50 and 150 µm. In this case, while the polarizing plate 110, 120 maintains the optical characteristic, the optical stack having a thin thickness can be manufactured.

The transparent conductive layer 110-2, 120-2 is provided to drive the liquid crystal layer 130 to be described below, and may be formed by directly contacting with the polarizing plate 110, 120. For example, as shown in FIG. 2, the first transparent conductive layer 110-2 and the second transparent conductive layer 120-2 may be respectively formed by directly contacting with the first polarizing plate 110 and the second polarizing plate 120.

Conventionally, an optical stack used to manufacture a smart window, etc. is manufactured by forming a conductive layer for driving a liquid crystal on one surface of a substrate and bonding-coupling a second surface of the substrate to a polarizing plate. However, according to the present disclosure, the variable transmittance optical stack has the conductive layer directly formed on one surface of the polarizing plate without a separate or additional substrate for forming the conductive layer, and thus is characterized to improve the transmittance in the light transmissive mode and the curvature characteristic while reducing the entire thickness of the laminate.

According to the embodiment, the transparent conductive layer 110-2, 120-2 may be formed by being directly deposited on one surface of the polarizing plate 110, 120. At this point, in order to improve the adhesion between the transparent conductive layer and the polarizing plate 110,120, the transparent conductive layer may be formed by performing pre-processing such as a corona processing or a plasma processing on one surface of each polarizing plate 110, 120, and then directly contacting with the surface of each polarizing plate to which the pre-processing is performed. The pre-processing is not limited to the corona processing or the plasma processing, and may adopt a pre-processing currently developed or to be developed without harming the purpose of the present disclosure.

According to another embodiment, in order to improve the adhesion between the transparent conductive layer 110-2, 120-2 and the polarizing plate, the transparent conductive layer 130 may be formed by directly contacting with each polarizing plate with the highly adhesive layer (not shown) located therebetween, the highly adhesive layer being provided on one surface of each polarizing plate. The highly adhesive layer may use a material of an adhesive and/or a pressure sensitive adhesive described in the pressure sensitive adhesive/adhesive layer among other members to be described below, but is not limited thereto.

The transparent conductive layer 110-2, 120-2 is preferably have the transmittance with respect to visible light of 50% or more, and for example, may include one or more types selected from a group consisting of transparent conductive oxide, metal, a carbonaceous material, conductive polymer, conductive ink, and nanowires, but the present disclosure is not limited thereto, and a material of a transparent conductive layer currently developed or to be developed may be used.

According to one or a plurality of embodiments, the transparent conductive oxide may include one or more types selected from a group consisting of indium tin oxide (ITO), indium zinc oxide (IZO), indium zinc tin oxide (IZTO), aluminum zinc oxide (AZO), gallium zinc oxide (GZO), florin tin oxide (FTO), zinc oxide (ZnO), etc. Furthermore, the metal may include one or more types selected from a group consisting of aurum (Au), argentum (Ag), cuprum (Cu), aluminum (Al), platinum (Pt), palladium (Pd), chromium (Cr), titanium (Ti), tungsten (W), niobium (Nb), tantalum (Ta), vanadium (V), iron (Fe), manganese (Mn), cobalt (Co), nickel (Ni), zinc (Zn), alloy containing at least one of them, etc., and for example, may include argentum - palladium - cuprum (APC) alloy or cuprum - calcium (CuCa) alloy. The carbonaceous matter may include one or more types selected from a group consisting of carbon nanotube (CNT), graphene, etc., and the conductive polymer may include one or more types selected from a group consisting of polypyrrole, polythiophene, polyacetylene, PEDOT, polyaniline, etc. The conductive ink may be a mixture of metal powder and curable polymer binder, and the nanowires may be for example silver nanowires (AgNW).

Furthermore, the transparent conductive layer 110-2, 120-2 may be formed by combining these matters in a structure of two or more layers. For example, in order to reduce the reflectance of incident light and increase the transmittance, the transparent conductive layer may be formed in a structure of two layers including a metal layer and a transparent conductive oxide.

The transparent conductive layer 110-2, 120-2 may be formed in a method commonly used in the art and, for example, may be formed using a coating process such as a spin coating method, a roller coating method, a bar coating method, a dip coating method, Gravure coating method, a curtain coating method, a dye coating method, a spray coating method, a doctor coating method, a kneader coating method, etc.; a printing process such as a screen printing method, a spray printing method, an inkjet printing method, a letterpress method, an intaglio printing method, a lithography method, etc.; and a deposition process such as chemical vapor deposition (CVD), physical vapor deposition (PVD), plasma enhanced chemical vapor deposition (PECVD) , etc.

The liquid crystal layer 130 may adjust transmittance of light incident in one or a plurality of directions according to electric fields to change a driving mode of the optical stack.

The liquid crystal layer 130 may include liquid crystal compounds and, for example, in an optical control region, may be located in a space provided by a sealant layer (not shown) and a spacer (not shown) that are provided between the first polarizing plate 100 and the second polarizing plate 120.

The liquid crystal compounds are driven in response to electric fields and is not particularly limited as long as it can control transmittance of light, and liquid crystal compounds currently developed or to be developed may be used and, for example, the description of reactive liquid crystal compound of the above-mentioned coatable polarizer may be equally applied thereto.

According to an embodiment, the liquid crystal layer 130 may be operated in the twisted nematic (TN) mode. In this case, a transmittance variation range between the transmissive mode and the light blocking mode of the optical stack may be improved by the optical design with the polarizing plate 110, 120, and it is advantageous in terms of the ease of enlarging the optical stack.

The spacer may include at least one spacer among a ball spacer and a column spacer, and specifically, may preferably be a ball spacer. The ball spacer may include one or more ball spacers, and preferably has a diameter between 1 and 10 µm. Furthermore, when viewed in a planar direction, a region where the ball spacer is occupied in the liquid crystal layer 130 is preferably 0.01 to10% of the area of the liquid crystal layer 130 in an aspect of improvement of user's visibility and transmittance in a light transmissive mode, and is not limited thereto.

According to an embodiment, the liquid crystal layer 130 may include other members within a range that does not damage the objectives of the present disclosure. For example, the liquid crystal layer 130 may include the sealant, the alignment film, the pressure sensitive adhesive/adhesive layer, the UV ray absorption layer, etc., and may be formed on each of the opposite surfaces of the liquid crystal layer 130 including a liquid crystal compound.

The sealant may include curable resins as base resins. As the base resins, UV curable resins or heat curable resins that are known to be usable for sealants in the art may be used. The ultraviolet curable resins may be polymers of UV curable monomers. The heat curable resins may be polymers of heat curable monomers.

As the base resins of the sealant, for example, acrylate-based resins, epoxy-based resins, urethane-based resins, phenol-based resins, or compounds of these resins. According to an embodiment, the base resins may be acrylate-based resins, and the acrylate-based resins may be polymers of acrylic monomers. For example, the acrylic monomers may be multifunctional acrylate. According to another embodiment, the sealant may include monomer substances in addition to the base resins. For example, the monomer substances may be monofunctional acrylate. In the specification, the monofunctional acrylate may mean compounds having one acryl group, and the multifunctional acrylate may mean compounds having two or more acryl group. The curable resins may be cured by UV irradiation and/or heating. The UV irradiation condition or heat condition may be performed appropriately within the scope that does not damage the objective of the present disclosure. In case of need, the sealant may include initiators, for example, photoinitiators or heat initiators.

The sealant may be provided in a method commonly used in the art and, for example, may be formed drawing a sealant at an outer portion of the liquid crystal layer (i.e., inactivate region) with a dispenser having a nozzle.

The alignment film is not particularly limited as long as it adds the orientation to the liquid crystal compounds. For example, the alignment film may be manufactured by coating and hardening an alignment film coating composition containing aligned polymers, photopolymerization initiators, and solvent. Although the aligned polymer is not particularly limited, the aligned polymer may be polyacrylate-based resin, polyamic resin, polyimide-based resin, polymer having cinnamate groups, etc. and may use polymer capable of expressing orientation, the polymer being currently developed or to be developed.

The pressure sensitive adhesive/adhesive layer may be formed using an adhesive or a pressure sensitive adhesive, and have appropriate pressure sensitive adhesion/adhesion to prevent peeling, bubbles, etc. from occurring when handling the optical stack, and preferably have transparency and thermal stability.

The adhesive may adopt an adhesive currently developed or to be developed, for example, may use photocurable adhesive. The photocurable adhesive provides strong adhesion by being crosslinked and cured by receiving active energy rays such as ultraviolet (UV), electron beam (EB), etc., and may be composed of reactive oligomers, reactive monomers, photopolymerization initiators, and the like.

The reactive oligomers are important components that determine the properties of adhesive, and form polymer binding by photopolymerization to form a cured film. For example, the available oligomers may be polyester-based resin, polyether-based resin, polyurethane-based resin, epoxy-based resin, polyacryl-based resin, silicon-based resin, and the like.

The reactive monomers may serve as crosslinker, diluent of the reactive oligomers described above, and affect adhesion characteristics. For example, the available reactive monomers may be monofunctional monomers, multifunctional monomers, epoxy-based monomers, vinyl ethers, cyclic ethers, and the like.

The photopolymerization initiator may absorb light energy to generate radicals or cations to initiate photopolymerization, and a proper kind may be selected and used depending on photopolymerization resin.

The pressure sensitive adhesive may use a pressure sensitive adhesive currently developed or to be developed. According to one or a plurality of embodiments, as the pressure sensitive adhesive, acrylic-based pressure sensitive adhesive, rubber-based pressure sensitive adhesive, silicon-based pressure sensitive adhesive, urethane-based pressure sensitive adhesive, polyvinyl alcohol-based pressure sensitive adhesive, polyvinyl pyrrolidone-based pressure sensitive adhesive, polyacrylamide-based pressure sensitive adhesive, cellulose-based pressure sensitive adhesive, vinylalky ether-based pressure sensitive adhesive and the like. The pressure sensitive adhesive is not particularly limited as long as it has pressure sensitive adhesion and viscoelasticity. For ease of acquisition, preferably, the pressure sensitive adhesive may include acrylic-based pressure sensitive adhesive, for example, may be (meth) acrylate copolymers, crosslinkers, solvents, and the like.

The crosslinkers may adopt crosslinkers currently developed or to be developed and, for example, polyisocyanate compounds, epoxy resins, melamine resins, urea resins, dialdehydes, methylol polymers, etc., and may preferably include polyisocyanate compounds.

The solvents may include common solvents used in the field of resin compositions. For example, the solvents may use solvents such as: alcohol-based compounds such as methanol, ethanol, isopropanol, butanol, propylene glycol methoxy alcohol, and the like; ketone-based compounds such as methyl ethyl ketone, methyl butyl ketone, methyl isobutyl ketone, diethyl ketone, dipropyl ketone, and the like; acetate-based compounds such as methyl acetate, ethyl acetate, butyl acetate, propylene glycol methoxy acetate, and the like; cellosolve-based compounds such as methyl cellosolve, ethyl cellosolve, propyl cellosolve, etc.; hydrocarbon-based compounds such as hexane, heptane, benzene, toluene, xylene, and the like. The solvents may be used alone or combination of two or more types.

The thickness of the pressure sensitive adhesive/adhesive layer may be appropriately determined depending on a kind of resins serving as the pressure sensitive adhesive/adhesive, the strength of the pressure sensitive adhesive/adhesive, the environment where the pressure sensitive adhesive/adhesive is used, and the like. According to an embodiment, the pressure sensitive adhesive/adhesive layer may have a thickness between 0.01 and 50µm in order to ensure sufficient adhesion and minimize the thickness of the optical stack and, preferably, may have a thickness between 0.05 and 20 µm and, more preferably, may have a thickness between 0.1 and 10µm, but is not limited thereto.

The ultraviolet ray absorption layer is not particularly limited as long as it is to prevent deterioration of the optical stack due to UV rays. For example, the ultraviolet ray absorption layer may use salicylic acid-based ultraviolet absorber (phenyl salicylate, p-tert-butylsalicylate, etc.), benzophenone-based ultraviolet absorber(2,4-dihydroxybenzophenone, 2,2'-dihydroxy-4,4'-dimethoxybenzophenone, etc.), benzotriazole-based ultraviolet absorber (2-(2'-hydroxy-5'-methylphenyl)benzotriazole, 2-(2'-hydroxy-3',5'-di-tert-butylphenyl)benzotriazole, 2-(2'-hydroxy-3'-tert-butyl-5'-methylphenyl)benzotriazole, 2-(2'-hydroxy-3',5'-di-tert-butylphenyl)-5-chlorobenzotriazole, 2-(2'-hydroxy-3'-(3",4",5",6"-tetrahydrophthalimide methyl)-5'-methylphenyl)benzotriazole, 2,2-methylenebis(4-(1,1,3,3-tetramethylbutyl)-6-(2H-benzotriazole-2-yl)phenol), 2-(2'-hydroxy-3'-tert-butyl-5'-methylphenyl)-5-chlorobenzotriazole, 2-(2'-hydroxy-3'-tert-butyl-5'-(2-octyloxicarbonylethyl)-phenyl)-5-chlorobenzotriazole, 2-(2'-hydroxy-3'-(1-methyl-1-phenylethyl)-5'-(1,1,3,3-tetramethylbutyl)-phenyl)benzotriazole, 2-(2H-benzotriazole-2-yl)-6-(linear and side chain dodecyl)-4-methylphenol, octyl-3-[3-tert-butyl-4-hydroxy-5-(chloro-2H-benzotriazole-2-yl)phenyl]propionate and 2-ethylhexyl-3-[3-tert-butyl-4-hydroxy-5-(5-chloro-2H-benzotriazole-2-yl)phenyl]propionate compounds, etc.), cyanoacrylate-based ultraviolet absorber(2'-ethylhexyl-2-cyano-3,3-diphenylacrylate, ethyl-2-cyano-3-(3',4'-methylene dioxyphenyl)-acrylate, etc.), triazine-based ultraviolet absorber, etc.. The benzotriazole-based ultraviolet absorber or the triazine-based ultraviolet absorber that have high transparency and the excellent effect of preventing deterioration of the polarizing plate or the variable transmittance layer may be preferably used as the ultraviolet ray absorption layer, and the benzotriazole-based ultraviolet absorber having more appropriate spectral absorption spectroscopy absorption spectrum may be preferable. The benzotriazole-based ultraviolet absorber may be changed into "-Bis" and, for example, may be 6,6'-methylenebis(2-(2H-benzo[d][1,2,3]triazole-2-yl)-4-(2,4,4-trimethylpentane-2-yl)phenol), 6,6'-methylenebis(2-(2H-benzo[d][1,2,3]triazole-2-yl)-4-(2-hydroxyethyl)phenol), etc.

### <Manufacturing method for variable transmittance optical stack>

The present disclosure includes a manufacturing method for the variable transmittance optical stack described above. The manufacturing method for the variable transmittance optical stack is not particularly limited, and may manufacture the optical stack by using any bonding technique or the above-described photolithography technique.

For example, formation of the conductive layer in the polarizing plate is performed by a composition for forming a functional conductive layer on a coating cellulose triacetate film or a cyclo-olefin polymer (COP) then bonding the coated layer with a polyvinyl alcoholic polarizer, and by selectively coating a functional conductive composition on a cellulose triacetate film surface or a cyclo-olefin film surface of the polarizing plate formed by bonding a cellulose triacetate film or a coating cellulose triacetate film and a cyclo-olefin film on opposite surfaces of a polyvinyl alcoholic polarizer (23 µm, KURARAY) with an adhesive.

### < Smart window >

In addition to the optical stack, the present disclosure includes a smart window including the same. Furthermore, the present disclosure includes a vehicle in which the smart window is applied to at least one of front windows, rear windows, side windows, sunroof windows, and inner partitions, and a building window including the smart window.

A vehicle including the smart window of the present disclosure may be formed by bonding a glass for a vehicle by using an adhesive on opposite surfaces of the optical stack including the liquid crystal layer and the optical functional layer. For example, the smart window may be formed by placing an adhesive film and a glass for a vehicle on opposite surfaces of the optical stack and heating the layer at a temperature of 90°C under 1bar or a vacuum state for 10 to 20 minutes by using a press machine, and coating resin on one surface of the glass for a vehicle and then vacuum bonding glasses for a vehicle on opposite surfaces of the optical stack and performing UV curing thereon. The adhesive film may include an EVA (ethylenevinylacetate) film, a PVB (polyvinylbutiral) film, etc., and the resin may include an OCR resin having storage modulus G' of between 10³ and 10⁵ Pa.

Furthermore, smart window products for window and doors may be manufactured such that windows and doors for a building (a glass for windows and doors) may be bonded on one or both surfaces of the optical stack or a glass for windows and doors may be bonded on one surface of the optical stack in a stacking manner, and the smart window products may be manufactured by bonding glasses for windows and doors on opposite surfaces of the optical stack after UV adhesive and then performing UV curing.

Hereinbelow, an embodiment of the present disclosure will be described in detail. However, the present disclosure may not be limited to embodiments disclosed below and may be implemented in various shapes, and the embodiments merely ensure that the present disclosure of the present disclosure is complete and is provided to fully inform those skilled in the art of the scope of the invention, and may be defined by the scope of the claims. In examples, "%" and "part" are "% by weight" and "part by weight", respectively, unless otherwise specified.

### Manufacturing example 1: manufacturing of coatable polarizer composition

According to the synthesized method of compounds 1 to 6 described in Lub et al., Recl. Trav. Chim. Pays-Bas, 115, 321-328 (1996), a compound A represented by the following structural formula was synthesized.

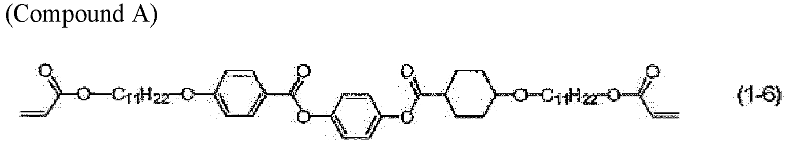

Thereafter, the coatable polarizer composition is manufactured by mixing 100 parts by weight of the compound A , 2 parts by mass of an azodye (NKX2029, manufactured by Hayashibara Seibutsu Kagaku Kenkyujo Company), 6 parts by weight of 2-dimethylamino-2-benzyl-1-(4-morpholinophenyl)butane-1-on(Irgacure 369, manufactured by BASFJAPAN Company) as a polymerization initiator, 2 parts by weight of isopropylthioxanthone (manufactured by Nihon SiberHegner Company) as a sensitizing agenet, 1.2 parts by weight of polyacrylate compound (BYK-361N, manufactured by BYK-Chemie Company) as a leveling agent, and 250 parts by weight of cyclopentanone as a solvent, and stirring the mixture at 80°C for 1 hour.

### Manufacturing example 2: manufacturing of composition for forming alignment film

Represented with the following structural formula, 2 parts of oriented material compound B synthesized by the method disclosed in Japanese Patent Application Publication No. 2013-33248 are mixed with 98 parts of o-Xylene (Daejung chemicals&metals company) as a solvent, and the resulting mixture is stirred at 80°C for 1 hour to obtain a composition for forming the alignment film.

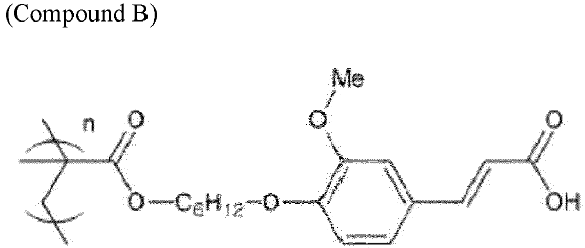

### Manufacturing example 3: manufacturing of composition for forming hard coating layer

The hard coating composition is manufactured by mixing 30 parts by weight of polyfunctional acrylate (Miwon Specialty Chemical Company, MIRAMER M340), 50 parts by weight of propyleneglycolmonomethylether dispersion ofnano silica sol (12nm, 40% solid content), 17 parts by weight of ethyl acetate, 2.7 parts by weight of an photoinitiator (Ciba Company, I-184), 0.3 parts by weight of silicone based additives (BYK Company, BYK-UV3530), by suing a stirrer, and filtering the mixture by using a filter of a polypropylene (PP) material.

### Manufacturing example 4: manufacturing of hard coating layer

The hard coating film is manufactured by coating the composition for forming a hard coating layer in Manufacturing example 3 on a transparent cellulose triacetate (TAC) film of KONICA Company, KC4UAW (40um), or a TAC retardation film KC3PR-1 of KONICA Company (Re 53nm, Rth 128nm), and then by curing a solvent and performing UV curing.

### Manufacturing example 5: manufacturing of first polarizing plate including coatable polarizer

The alignment film of a thickness of 0.3µm is manufactured by applying the composition for forming an alignment film in the manufacturing example 2 for aligning a polarized coating layer (CPOL) on the hard coating layer in the manufacturing example 4 in the die coating method and drying the layer, and then emitting UV passing through a grid so that the alignment film is aligned in a specific direction. Furthermore, the polarized coating layer (CPOL) of a thickness of 2µm is manufactured by coating the coatable polarizer composition in the manufacturing example 1 on the alignment film in the die coating method and solvent-drying the coated part and emitting UV passing through a wire grid.

Furthermore, as an adhesive, a water-based adhesive containing 5 parts by weight of acetoacetyl group degeneration polyvinylalcohol-based resin (cocenol Z200, Japan synthetic chemistry industry Company) with respect to 100 parts by weight of water. Thereafter, by using the prepared UV adhesive, a surface of the polarized coating layer (CPOL) and a surface of the TAC film in the manufacturing example 4 are bonded while being arranged as facing two surfaces. The UV exposure is performed to the obtained laminate, and the adhesive is cured to manufacture the first polarizing plate that is a conductive coating polarizing plate laminate. Furthermore, a thickness of the adhesive layer with respect to the obtained first polarizing plate is about 2µm.

### Manufacturing example 6: manufacturing of second polarizing plate

### including a stretched polarizer

### (1) Swelling treatment process

A polyvinylalcohol film (material film)(manufactured by Kurarey Company, product name ^{┌}Kuraray Poval Film VF-PE # 6000_{┘} , average polymerization degree 2400, saponification degree 99.9 mol%) of a thickens of 60µm is returned while continuing to unroll the film from the material roll, and the film is immersed in a swelling bath added with pure water of 20°C for 30 seconds. In the swelling treatment process, stretching (vertical uniaxial stretching) between rolls is performed with adding a difference in main speed between nip rolls. Stretching magnification based on the material film is preset at 3.5 times.

### (2) Dyeing treatment process

Next, the film passing through the nip rolls is immersed in a dyeing bath at 30°C with a mass ratio of pure water/potassium iodide/iodine/boracic acid of 100/2/0.01/0.3 for 120 seconds. Also in the dyeing process, stretching between rolls (vertical uniaxial stretching) is performed with adding a difference in main speed between the nip rolls. Stretching magnification based on the film after the swelling treatment process is preset at 1.1 times.

### (3) Crosslinking treatment process

Next, the film passing through the nip rolls is immersed in a first crosslinking bath at 56°C with a mass ratio of pure water/potassium iodide/boracic acid of 100/12/4. Stretching between rolls (vertical uniaxial stretching) is performed while adding a difference in main speed between a nip roll and another nip roll provided between the first crosslinking bath and a second crosslinking bath. Stretching magnification based on the film after the dyeing treatment process is preset at 1.9 times.

### (4) Complementary color treatment process

Next, the film after the crosslinking treatment process is immersed in the second crosslinking bath at 40°C with a mass ratio of potassium iodide/boracic acid/pure water of 9/2.9/100 for 10 seconds.

### (5) Cleaning treatment process

Next, the film after the second crosslinking treatment process is immersed in a cleaning bath added with pure water at 14°C for 5 seconds, and cleaning the film with shower amount of 5m³/h and shower the film at 14°C.

At this point, [PVA+I3-] complex absorbing a short-wavelength range is weak to water, so that a value of b* of a short-form transparent color is significantly changed according to a temperature of a cleaning liquid, a residence time of a cleaning liquid, amount of shower, a shower temperature, a PVA moisture rate.

### (6) Drying treatment process

Next, the polarizer film is manufactured by heating-drying the film at 80°C for 190 seconds by passing the film after the cleaning treatment process through a dry passage. A moisture rate after drying is 13.6%, and a thickness of the obtained polarizer film is about 21µm.

### (7) Bonding treatment process

Next, as an adhesive, a water-based adhesive containing 5 parts by weight of acetoacetyl group degeneration polyvinylalcohol-based resin (Cocenol Z200, Japan synthetic chemistry industry Company) with respect to 100 parts by weight of water. Thereafter, the protective films are laminated on opposite sides of the polarizer film such that the TAC surface in the manufacturing example 4 and the transparent cellulose triacetate film (TAC, 40µm) face the polarizer by using the prepared UV adhesive. The second polarizing plate including the stretched polarizer is manufactured by performing UV exposure to the obtained stack and by curing the adhesive. Furthermore, a thickness of the adhesive layer to the obtained second polarizing plate is about 2µm.

### Manufacturing example 7: manufacturing of transparent conductive layer

The transparent conductive film (90nm) is formed by manufacturing the polarizing plate and the second polarizing plate according to the manufacturing example 5 and 6, applying DC power of 450W on the polarizing plate to operate a sputter gun, and inducing plasma to a target of ITO (10wt% Sn doped In₂O₃). An ion gun is operated with DC power of 50W to ionize the formed transparent conductive film. At this point, the transparent conductive film is manufactured by maintaining pressure at room temperature at 3mTorr and supplying argon gas and oxygen gas at 30sccm and 1sccm, respectively. At this point, ITO performance is measured such that an ITO thickness is measured by FT-SEM and an ITO surface resistance (Ω/□) is measured by the four point probe.

### Manufacturing example 8: manufacturing of distribution of ball spacer

A mixed solvent is manufactured by mixing a ball spacer of 0.03g (SEKISUI Company SP-210) based on IPA of 100ml. The polarizing plate is inserted into the spacer spreader (SDSS-KHU02, Shindo Company), and the manufactured mixed solvent is spread under a condition of 110°C and then is dried for 20 minutes, and thus the ball spacer is formed on the alignment film of the second polarizing plate.

### Manufacturing example 9: manufacturing of sealant

On the transparent conductive layer of the second polarizing plate manufactured as described above, by using the sealant dispenser (SHOTmini 200Ω x, USASHI Company), the sealant (UVF-006, 70,000 mPa·s, SEKISUI Company) is applied at discharge pressure of 200mPa according to a product size drawing by using a sharp needle (SPN-0.25-12.7L), and a liquid crystal driven in the twisted nematic (TN) mode is injected to on the alignment film an ODF process method. Thereafter, while the transmission axi of the first polarizing plate and the second polarizing plate are arranged at 90° from each other and the machine directions MD are arranged in parallel to each other (0°) in a planar direction, the first polarizing plate and the second polarizing plate are bonded at pressure of 3kg/cm² and then UV cured (500mJ/cm²) along the sealant line.

### Examples and comparative examples: manufacturing of optical stack

The optical stack is manufacture by applying the manufacturing examples 1 to 9. In each example and each comparative example, the polarizers of the first polarizing plate and the second polarizing plate are preset to follow the contents described in the Table 1.

**[Table 1]**

| | First polarizing plate | Second polarizing plate |
|---|---|---|
| Example 1 | stretched polarizer | coatable polarizer |
| Example 2 | coatable polarizer | coatable polarizer |
| Comparative example 1 | stretched polarizer | stretched polarizer |

| | | |
|---|---|---|
| -the stretched polarizer: the stretched polarizer of the manufacturing example 6 -the coatable polarizer: the coatable polarizer of the manufacturing example 5 | | |

### Experimental examples

### (1) Visible ray transmittance evaluation

For the optical stack of each of the examples and the comparative examples, transmittance in a voltage application (ON) state and a voltage non-application state (OFF) are measured by using CM3700 (Konica Minolta), and resulted values are represented in Table 2.

### (2) Roll-to-roll suitability evaluation

For performing an ON, OFF operation, it is preferable that the transmission axis of the first and second polarizers are arranged perpendicular to each other. The evaluation is performed to the optical stack of each of the examples and the comparative examples according to whether or not change of the transmission axis is possible, and resulted values are represented in Table 2.

Since stretching of the stretched polarizer is performed in the machine direction, the machine direction serves as the absorption axis and a direction perpendicular thereto serves as the transmission axis, and it is not easy to change the transmission axis. In the coatable polarizer, a directional adjustment of the transmission axis or the absorption axis in plane is efficiently performed by adjusting a polarization direction in the UV curing process.

Therefore, when configuration of the comparative example 1 is applied to the roll-to-roll process such that the machine directions of the two polarizers are in parallel, the transmission axis thereof are in parallel to each other and ON/OFF operation according to voltage is difficult. In the configuration of the example 1 and 2, the transmission axis direction of the coatable polarizer is adjustable so that the configuration is applicable to the roll-to-roll process efficiently.

### <Evaluation standard>

○: change of a transmission axis of a polarizer is possible
x: change of a transmission axis of a polarizer is impossible

### (3) Handling property evaluation

With respect to handling properties of the optical stack of each of the examples and the comparative examples manufactured according to the manufacturing examples 1 to 9 and Table 1, the yield is verified based on each of 200 pieces of 32 inches products. In darkroom environment, defects visible to the naked eye under the LED light source are selected, and the defects are classified according to occurrence rate of handling defects (breaking, stabbing, etc.), and the results are represented in Table 2. When a thickness of the film is reduced, defects of the film may occur due to a speed of a moving product and a step difference between facilities in the cutting process.

### <Evaluation standard>

○: when handling occurring rate of defects is less than or equal to 1%
△: when handling occurring rate of defects is more than 1% and equal to or less than 5%
x: when handling occurring rate of defects is more than 5% and less than or equal to 10%

**[Table 2]**

| | Transmittance | | Roll-to-roll suitability | Handling property |
|---|---|---|---|---|
| | Voltage OFF (Tmax) | Voltage ON (Tmin) | | |
| Example 1 | 32.5% | 0.1% | ○ | ○ |
| Example 2 | 33.4% | 0.2% | ○ | Δ |
| Comparative example 1 | 31.6% | 0.0% | x | Δ |

Referring to the experimental data, since the variable transmittance optical stack according to the present disclosure uses only the stretched polarizer to each of the first polarizing plate and the second polarizing plate, in comparison to the comparative 1 without the coatable polarizer, it may be confirmed that the variable transmittance optical stack is good in terms of handlingability when the variable transmittance optical stack with a large area is manufactured by the roll-to-roll manufacturing process.

## Claims

1. A variable transmittance optical stack comprising:
a liquid crystal layer;
a first transparent conductive layer formed on a first surface of the liquid crystal layer;
a second transparent conductive layer formed on a second surface of the liquid crystal layer;
a first polarizing plate formed on the first transparent conductive layer; and
a second polarizing plate formed on the second transparent conductive layer,
wherein at least one polarizing plate of the first polarizing plate and the second polarizing plate comprises a coatable polarizer, and
each transmission axis of the first polarizing plate and the second polarizing plate is vertical.

2. The variable transmittance optical stack of claim 1, wherein machine directions (MD) of the first polarizing plate and the second polarizing plate are in parallel to each other.

3. The variable transmittance optical stack of claim 1 or 2, wherein the first polarizing plate comprises a stretched polarizer, and the second polarizing plate comprises the coatable polarizer.

4. The variable transmittance optical stack of one of claims 1 to 3, wherein the variable transmittance optical stack is manufactured by a roll-to-roll continuous process.

5. The variable transmittance optical stack of one of claims 1 to 4, wherein at least one polarizing plate of the first polarizing plate and the second polarizing plate comprises one or more types of a functional layer selected from a group consisting of a functional coating layer, a protective layer, a retardation matching layer, and a refractive index-matching layer.

6. The variable transmittance optical stack of one of claims 1 to 5, wherein at least one polarizing plate of the first polarizing plate and the second polarizing plate has a thickness ranging from 30 to 200µm.

7. The variable transmittance optical stack of one of claims 1 to 6, wherein at least one transparent conductive layer of the first transparent conductive layer and the second transparent conductive layer is formed by directly contacting with any one polarizing plate of the first polarizing plate and the second polarizing plate without an additional substrate between the polarizing plate and the transparent conductive layer.

8. The variable transmittance optical stack of one of claims 1 to 7, wherein at least one transparent conductive layer of the first transparent conductive layer and the second transparent conductive layer is formed by directly contacting with any one polarizing plate of the first polarizing plate and the second polarizing plate with a highly adhesive layer between the polarizing plate and the transparent conductive layer.

9. The variable transmittance optical stack of one of claims 1 to 8, wherein at least one transparent conductive layer of the first transparent conductive layer and the second transparent conductive layer comprises one or more types selected from a group consisting of transparent conductive oxide, metal, carbonaceous matters, conductive polymers, conductive ink, and nanowires.

10. The variable transmittance optical stack of one of claims 1 to 9, wherein the liquid crystal layer is driven in a twisted nematic (TN) mode.

11. The variable transmittance optical stack of one of claims 1 to 10, wherein the liquid crystal layer comprises one or more types of spacers selected from a group consisting of a ball spacer and a column spacer.

12. The variable transmittance optical stack of one of claims 1 to 11, wherein the variable transmittance optical stack further comprises one or more types selected from a group consisting of a sealant, an alignment film, a pressure sensitive adhesive/adhesive layer, and an ultraviolet ray absorption layer.

13. A manufacturing method for the variable transmittance optical stack of any one of claims 1 to 12.

14. The manufacturing method for the variable transmittance optical stack of claim 13, wherein the manufacturing method of the variable transmittance optical stack is characterized as being a roll-to-roll continuous process.

15. A smart window comprising the variable transmittance optical stack of any one of claims 1 to 12.
